# EUROPEAN PATENT APPLICATION

(11) **EP 4 020 542 A1**
(43) Date of publication of application: **29.06.2022**
(21) Application number: 20857916.9
(22) Date of filing: 16.04.2020
(51) Int. Cl.: H01L 23/12, H01P 3/02, H05K 3/46

(54) **WIRING SUBSTRATE**

(30) Priority: 23.08.2019 JP 2019152638
(71) Applicant: NGK SPARK PLUG CO., LTD., Mizuho-ku Nagoya-shi Aichi 467-8525 (JP)
(72) Inventor: KOBAYASHI, Hiroki, Nagoya-shi Aichi 467-8525 (JP)
(74) Representative: Cabinet Beau de Loménie
(86) International application number: PCT/JP2020/016784
(87) International publication number: WO 2021/038951

(57) **Abstract**

A wiring board 10 according to the present disclosure includes: a dielectric substrate 20; and a first wiring 60 and a second wiring 70 to which differential signals are input. The dielectric substrate 20 is configured by stacking a plurality of insulation layers. A first pad 61 and a second pad 71 to be connected to the element 11 are disposed on a first insulation layer 21 that is one of the plurality of insulation layers and that is located at an end portion in a stacking direction. The first wiring 60 includes a first via conductor 62 and a first planar conductor 63. The second wiring 70 includes a second via conductor that extends in the element connection portion 30 through the insulation layer in the stacking direction and a second planar conductor 73 that extends in a direction perpendicular to the stacking direction in the element connection portion 30 along the first insulation layer 21 or in the element connection portion 30 along the insulation layer that is closer than the first planar conductor 63 to the first insulation layer 21.

## Description

### Technical Field

The present disclosure relates to a wiring board.

### Background Art

To date, a wiring board described in Japanese Unexamined Patent Application Publication No. 2011-138845 (PTL 1), for example, is known as a wiring board on which a semiconductor element, such as a semiconductor integrated circuit element, is to be mounted. The wiring board includes: an insulation substrate that is formed by stacking a plurality of insulation layers; a plurality of wiring conductors that are disposed inside of and on a surface of the insulation substrate; and a via conductor that extends through insulation layers to connect upper and lower wiring conductors to each other. On a central part of an upper surface of the insulation substrate, a semiconductor element connection pad, which is to be electrically connected to an electrode terminal of a semiconductor element through a solder bump or the like, is formed. On a lower surface of the insulation substrate, an external connection pad, which is to be electrically connected to a wiring conductor of an external electric circuit board through a solder ball or the like, is formed. The semiconductor element connection pad and the external connection pad are electrically connected to each other through a wiring conductor and a via conductor.

According to Figs. 2 and 3 of Japanese Unexamined Patent Application Publication No. 2011-138845, a pair of semiconductor element connection pads 32 are connected to a pair of strip wiring conductors 72 through via conductors 51b, lands 82b, via conductors 52b, lands 83b, via conductors 53b, lands 84b, via conductors 54b, and lands 85b. The pair of strip wiring conductors 72 is configured as a pair transmission line that functions as differential lines relative to each other as a signal transmission line. The pair transmission line is formed by: providing a pair of strip wiring conductors that extend parallel to each other at a predetermined distance; providing ground or power-supply conductors above and below or leftward and rightward of the pair of strip wiring conductors each at a predetermined distance; and achieving impedance matching.

### Citation List

### Patent Literature

PTL 1: Japanese Unexamined Patent Application Publication No. 2011-138845

### Summary of Invention

### Technical Problem

However, in the wiring board described above, an impedance mismatch part is long, because the via conductors that are used to connect the pair of strip wiring conductors to the upper and lower lands are provided in a pair so as to be adjacent to each other at a predetermined distance and because the pair of lands are disposed adjacent to each other at the same layer. Moreover, the wiring conductor has an extremely complex structure because, between the pair of strip wiring conductors and the pair of semiconductor element connection pads, the wiring conductor is configured in a step-like shape from a plurality of via conductors and a plurality of lands.

### Solution to Problem

A wiring board according to the present disclosure includes: a dielectric substrate; and a first wiring and a second wiring to which differential signals are input. The dielectric substrate is configured by stacking a plurality of insulation layers. The dielectric substrate includes an element connection portion to be connected to an element, an external connection portion to be connected to an external circuit board, and an intermediate connection portion that has a shape extending in a direction perpendicular to a stacking direction and that intermediately connects the element connection portion and the external connection portion. A first pad and a second pad to be connected to the element are disposed on a first insulation layer that is one of the plurality of insulation layers and that is located at an end portion in the stacking direction. The first wiring includes a first via conductor that extends in the element connection portion from the first pad through the plurality of insulation layers in the stacking direction and a first planar conductor that extends in the element connection portion in the direction perpendicular to the stacking direction along an intermediate insulation layer that is one of the plurality of insulation layers and that extends continuously to the intermediate connection portion. The second wiring includes a second via conductor that extends in the element connection portion through the insulation layer in the stacking direction and a second planar conductor that extends in the direction perpendicular to the stacking direction in the element connection portion along the first insulation layer or in the element connection portion along the insulation layer that is closer than the first planar conductor to the first insulation layer.

### Advantageous Effects of Invention

With the present disclosure, it is possible to reduce the length of an impedance mismatch part, to improve electric characteristics, and to simplify the structure of the first wiring.

### Brief Description of Drawings

[Fig. 1] Fig. 1 is a plan view of a wiring board according to the present disclosure as seen from above.
[Fig. 2] Fig. 2 is a sectional view illustrating the wiring structure of the wiring board according to the present disclosure.
[Fig. 3] Fig. 3 is a partial enlarged sectional view of Fig. 2 from which a middle part is omitted.
[Fig. 4] Fig. 4 is a plan view of a wiring board having an existing structure as seen from above.
[Fig. 5] Fig. 5 is a sectional view illustrating the wiring structure of the wiring board having the existing structure.
[Fig. 6] Fig. 6 is a partial enlarged sectional view of Fig. 5 from which a middle part is omitted.

### Description of Embodiments

### [Description of Embodiments of Present Disclosure]

First, embodiment modes of the present disclosure will be enumerated and described.

(1) A wiring board according to the present disclosure includes: a dielectric substrate; and a first wiring and a second wiring to which differential signals are input. The dielectric substrate is configured by stacking a plurality of insulation layers. The dielectric substrate includes an element connection portion to be connected to an element, an external connection portion to be connected to an external circuit board, and an intermediate connection portion that has a shape extending in a direction perpendicular to a stacking direction and that intermediately connects the element connection portion and the external connection portion. A first pad and a second pad to be connected to the element are disposed on a first insulation layer that is one of the plurality of insulation layers and that is located at an end portion in the stacking direction, The first wiring includes a first via conductor that extends in the element connection portion from the first pad through the plurality of insulation layers in the stacking direction and a first planar conductor that extends in the element connection portion in the direction perpendicular to the stacking direction along an intermediate insulation layer that is one of the plurality of insulation layers and that extends continuously to the intermediate connection portion. The second wiring includes a second via conductor that extends in the element connection portion through the insulation layer in the stacking direction and a second planar conductor that extends in the direction perpendicular to the stacking direction in the element connection portion along the first insulation layer or in the element connection portion along the insulation layer that is closer than the first planar conductor to the first insulation layer.

It is desirable that a part where the first via conductor and the second via conductor are disposed close to each other side by side be as short as possible, because impedance mismatch occurs in this part. In this respect, with the configuration according to claim 1, the second planar conductor is disposed along an insulation layer that is closer than the first planar conductor to the first insulation layer. Thus, it is possible to make the second via conductor shorter than the first via conductor. Accordingly, the impedance mismatch part can be made short, and electric characteristics can be improved.

Moreover, an end portion of the first via conductor is connected to the first planar conductor and the first wiring can be extended from an end portion of the first planar conductor to the intermediate connection portion at the same layer. Thus, it is not necessary to configure the first wiring in a step-like shape. Accordingly, the structure of the first wiring can be simplified.

(2) Preferably, the second via conductor includes a second front via conductor that extends from the second pad through at least one of the insulation layers toward a front end portion of the second planar conductor in the stacking direction and a second rear via conductor that extends from a rear end portion of the second planar conductor through the plurality of insulation layers in the stacking direction.

(3) Preferably, the second planar conductor is disposed along a stacking surface of a second insulation layer that is disposed at a layer adjacent to the first insulation layer.

Electric characteristics can be further improved, because the length of an impedance mismatch part can be limited to a length corresponding to one insulation layer.

(4) Preferably, the first wiring includes a first strip conductor that extends in the intermediate connection portion in the direction perpendicular to the stacking direction, the second wiring includes a second strip conductor that is at the same layer as the first strip conductor in the intermediate connection portion and that is disposed at a uniform distance from the first strip conductor, and the first strip conductor and the second strip conductor constitute a pair wiring.

In a case where the second planar conductor is not provided in the element connection portion, the pair wiring can be made longer than that of a case where the second planar conductor is provided in the element connection portion. Thus, an advantage can be obtained in this respect. However, in the case where the second planar conductor is not provided in the element connection portion, the impedance mismatch part is longer than that of the case where the second planar conductor is provided in the element connection portion. Thus, the electric characteristics of the entire wiring can be improved, even though the pair wiring is short.

(5) Preferably, a characteristic impedance of the first planar conductor is half a differential impedance of the pair wiring, and a characteristic impedance of the first planar conductor and a characteristic impedance of the second planar conductor are equal.

By setting the characteristic impedance of the first planar conductor and the characteristic impedance of the second planar conductor to be half (for example, 50 **Ω**) the differential impedance of the pair wiring (for example, 100 **Ω**), the irregularities of the impedance of the entire wiring can be reduced.

(6) Preferably, a length of the first planar conductor is less than or equal to half a length of the first strip conductor.

When the length of the first planar conductor is made less than or equal to half the length of the first strip conductor, the S parameter characteristics can be improved.

### [Details of Embodiments of the Present Disclosure]

Hereafter, specific examples of a wiring board 10 according to the present disclosure will be described with reference to the drawings. It is intended that the present disclosure is not limited to these examples, is represented by the claims, and includes all modifications within the scope of the claims and the equivalents thereof.

### [Overall Structure of Wiring Board]

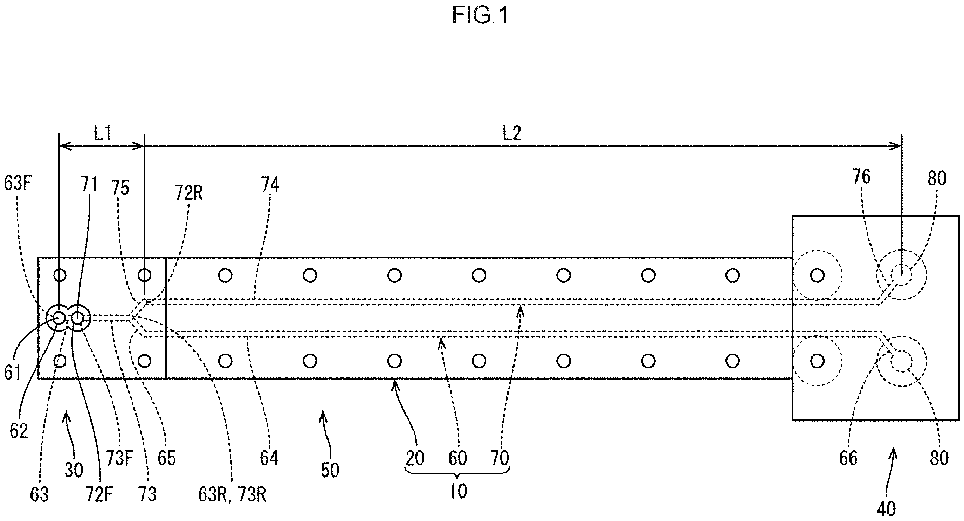

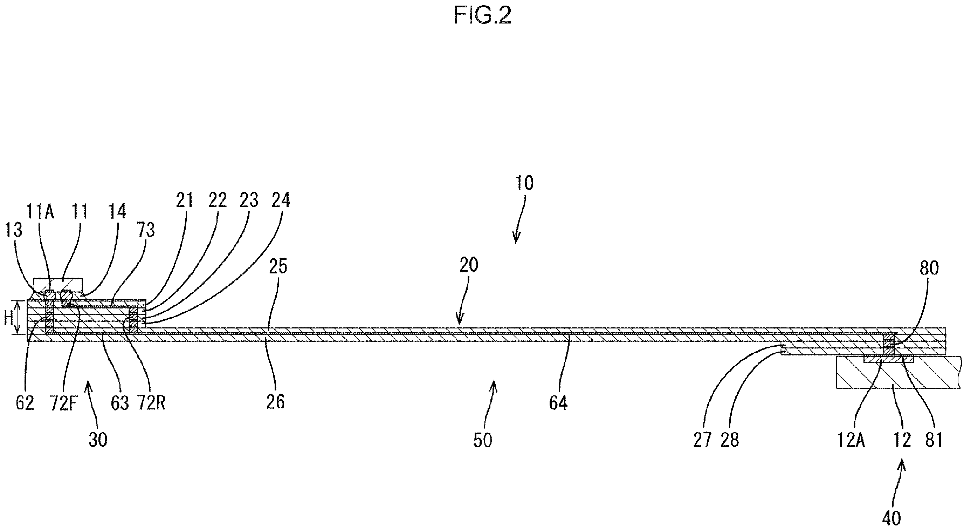

As illustrated in Figs. 1 and 2, the wiring board 10 includes a dielectric substrate 20, and a first wiring 60 and a second wiring 70 to which differential signals are input. The dielectric substrate 20 includes: an element connection portion 30 to be connected to an element 11; an external connection portion 40 to be connected to an external circuit board 12; and an intermediate connection portion 50 that has a shape extending in a direction perpendicular to the stacking direction and that intermediately connects the element connection portion 30, the element connection portion 30, and the external connection portion 40. Hereafter, the front-rear direction is defined in such a way that the element connection portion 30 side is the front side and the external connection portion 40 side is the rear side, with reference to the direction in which the intermediate connection portion 50 extends.

The dielectric substrate 20 is configured by stacking a plurality of insulation layers that include, from the top, a first insulation layer 21, a second insulation layer 22, a third insulation layer 23, a fourth insulation layer 24, a fifth insulation layer 25, a sixth insulation layer 26, a seventh insulation layer 27, and an eighth insulation layer 28. That is, the dielectric substrate 20 according to the present disclosure is constituted by eight insulation layers.

The first insulation layer 21, the second insulation layer 22, the third insulation layer 23, and the fourth insulation layer 24 are disposed in the element connection portion 30. The seventh insulation layer 27 and the eighth insulation layer 28 are disposed in the external connection portion 40. The fifth insulation layer 25 and the sixth insulation layer 26 are disposed so as to extend from the element connection portion 30 to the external connection portion 40 through the intermediate connection portion 50, and each have a shape elongated in a direction perpendicular to the stacking direction.

### [External Connection Portion]

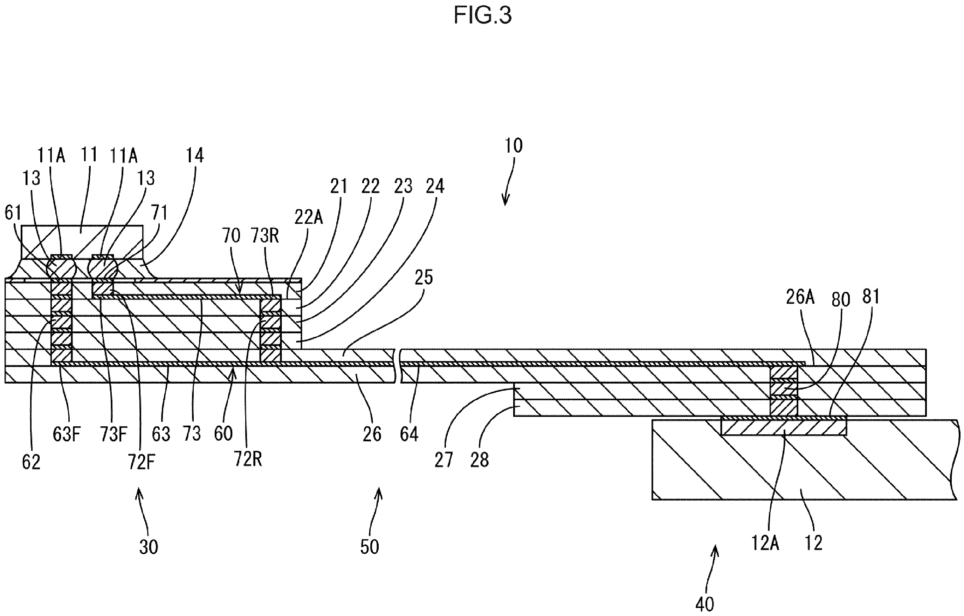

The external connection portion 40 includes a rear end portion of the fifth insulation layer 25, a rear end portion of the sixth insulation layer 26, the seventh insulation layer 27, and the eighth insulation layer 28. As illustrated in Fig. 3, a first strip conductor 64 (described below) of the first wiring 60 and a second strip conductor 74 (described below) of the second wiring 70 are disposed along a stacking surface 26A of the sixth insulation layer 26 on which the fifth insulation layer 25 is stacked.

### [Via Conductor]

Via conductors 80 are formed inside of the external connection portion 40. The via conductors 80 are formed so as to extend from the sixth insulation layer 26 to the eighth insulation layer 28. A land 81 is formed at a lower end portion of each via conductor 80. The land 81 is formed on a lower surface of the eighth insulation layer 28 so as to extend outward in the radial direction with the via conductor 80 as the center. As illustrated in Fig. 1, the land 81 is connected to a conductor 12A of the external circuit board 12.

### [Intermediate Connection Portion]

The intermediate connection portion 50 includes a central part, excluding front and rear end parts, of the fifth insulation layer 25 and a central part, excluding front and rear end parts, of the sixth insulation layer 26. As illustrated in Fig. 3, the first strip conductor 64 (described below) of the first wiring 60 is disposed along the stacking surface 26A of the sixth insulation layer 26 on which the fifth insulation layer 25 is stacked. Likewise, the second strip conductor 74 (described below) of the second wiring 70 is disposed along the stacking surface 26A of the sixth insulation layer 26 on which the fifth insulation layer 25 is stacked.

### [Element Connection Portion]

The element connection portion 30 includes the first insulation layer 21, the second insulation layer 22, the third insulation layer 23, the fourth insulation layer 24, a front end portion of the fifth insulation layer 25, and a front end portion of the sixth insulation layer 26. On an upper surface of the first insulation layer 21, a first pad 61, a second pad 71, and a plane that is a planar-shaped conductor formed so as to surround the pads 61 and 71 are disposed. An 8-shaped clearance is formed between the plane and the first and second pads 61 and 71. The second pad 71 is disposed behind the first pad 61. A plurality of electrodes 11A are provided on a lower surface of the element 11, a solder ball 13 is interposed between the first pad 61 and a corresponding one of the electrodes 11A, and a solder ball 13 is interposed between the second pad 71 and a corresponding one of the electrodes 11A. A space between the lower surface of the element 11 and the upper surface of the first insulation layer 21 is sealed with a sealant 14 such as a resin. Thus, the solder balls 13 are embedded inside of the sealant 14.

### [First Via Conductor, Second Via Conductor, and Planar Conductor]

A first via conductor 62 and a second via conductor are embedded inside of the element connection portion 30. The second via conductor includes a second front via conductor 72F and a second rear via conductor 72R that is located behind the second front via conductor 72F. The first via conductor 62 extends downward from the first pad 61 through a plurality of insulation layers (in the present disclosure, five insulation layers from the first insulation layer 21 to the fifth insulation layer 25), and a lower end portion of the first via conductor 62 is connected to a front end portion 63F of a first planar conductor 63. The first planar conductor 63 extends rearward in the element connection portion 30 along the stacking surface 26A of the sixth insulation layer 26.

The second front via conductor 72F extends downward from the second pad 71 through one insulation layer (in the present disclosure, only the first insulation layer 21), and a lower end portion of the second front via conductor 72F is connected to a front end portion 73F of a second planar conductor 73. The second planar conductor 73 extends rearward in the element connection portion 30 along a stacking surface 22A of the second insulation layer 22.

As illustrated in Fig. 1, the first planar conductor 63 and the second planar conductor 73 are disposed so as to overlap in plan view and extend rearward. A first inlet portion 65 and a second inlet portion 75 are connected to rear end portions 63R and 73R of the planar conductors 63 and 73. The first inlet portion 65 and the second inlet portion 75 extend diagonally rearward in plan view so as to become separated from each other. A rear end portion of the first inlet portion 65 and a rear end portion of the second inlet portion 75 are disposed so as to be separated by a predetermined distance.

The second rear via conductor 72R is connected to the rear end portion of the second inlet portion 75. The second rear via conductor 72R extends downward from the rear end portion of the second inlet portion 75 through a plurality of insulation layers (in the present disclosure, four insulation layers from the second insulation layer 22 to the fifth insulation layer 25).

### [First Strip Conductor and Second Strip Conductor]

The first strip conductor 64 is connected to the rear end portion of the first inlet portion 65. The first strip conductor 64 extends continuously to the rear end portion of the first inlet portion 65 in the element connection portion 30. The first strip conductor 64 extends rearward along the stacking surface 26A of the sixth insulation layer 26.

The second strip conductor 74 is connected to a lower end portion of the second rear via conductor 72R. The second strip conductor 74 extends continuously to the lower end portion of the second rear via conductor 72R in the element connection portion 30. The second strip conductor 74 extends rearward along the stacking surface 26A of the sixth insulation layer 26.

As illustrated in Fig. 1, the first strip conductor 64 and the second strip conductor 74 each have a shape extending linearly and are disposed at a uniform distance and parallel to each other. The first strip conductor 64 and the second strip conductor 74 form a pair wiring in a differential transmission line. The first strip conductor 64 and the second strip conductor 74 are disposed parallel to each other side by side from a position near the rear end of the element connection portion 30, across the intermediate connection portion 50 in the front-rear direction, to a position near the center of the external connection portion 40.

A first outlet portion 66, which extends to the via conductor 80, is connected to a rear end portion of the first strip conductor 64. Likewise, a second outlet portion 76, which extends to the via conductor 80, is connected to a rear end portion of the second strip conductor 74. The first outlet portion 66 and the second outlet portion 76 extend diagonally rearward in plan view so as to become separated from each other. A rear end portion of the first outlet portion 66 and a rear end portion of the second outlet portion 76 are respectively connected to the via conductors 80.

### [First Wiring]

The first wiring 60 includes the first pad 61, the first via conductor 62, the first planar conductor 63, the first inlet portion 65, the first strip conductor 64, the first outlet portion 66, the via conductor 80, and the land 81. The electrode 11A of the element 11 is connected to the first pad 61 of the first wiring 60 through the solder ball 13, and is connected to the conductor 12A of the external circuit board 12 through the land 81 of the first wiring 60. Accordingly, the element 11 is electrically connected to the external circuit board 12 through the first wiring 60.

### [Second Wiring]

The second wiring 70 includes the second pad 71, the second front via conductor 72F, the second planar conductor 73, the second inlet portion 75, the second rear via conductor 72R, the second strip conductor 74, the second outlet portion 76, the via conductor 80, and the land 81. The electrode 11A of the element 11 is connected to the second pad 71 of the second wiring 70 through the solder ball 13, and is connected to the conductor 12A of the external circuit board 12 through the land 81 of the second wiring 70. Accordingly, the element 11 is electrically connected to the external circuit board 12 through the second wiring 70.

### [Impedance Characteristics]

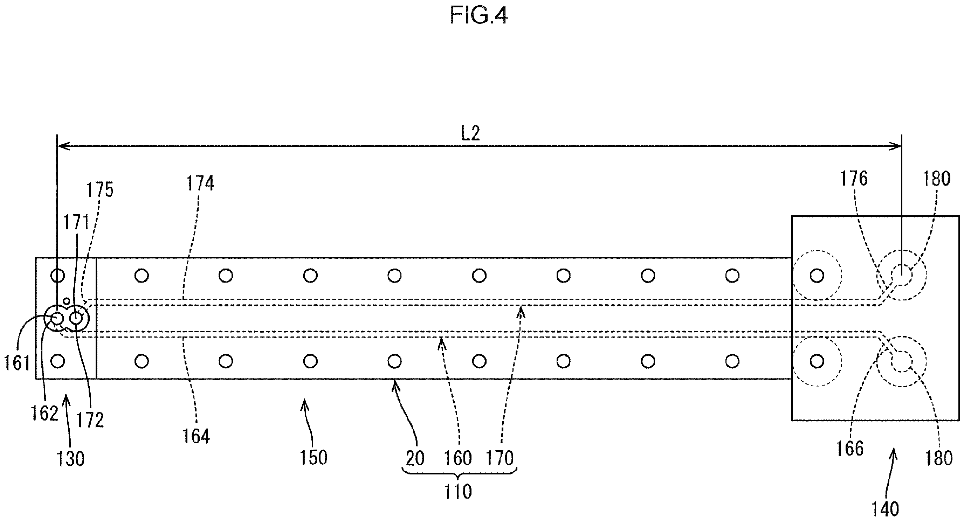

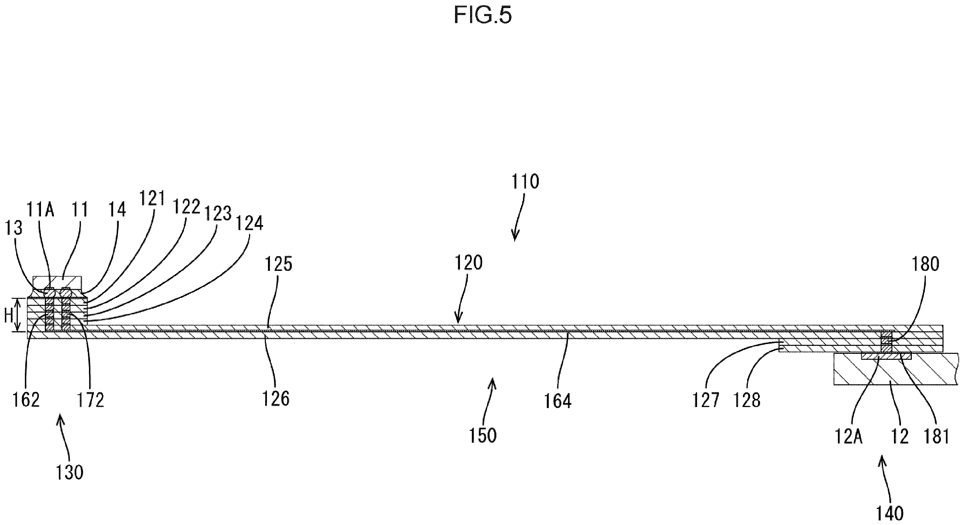

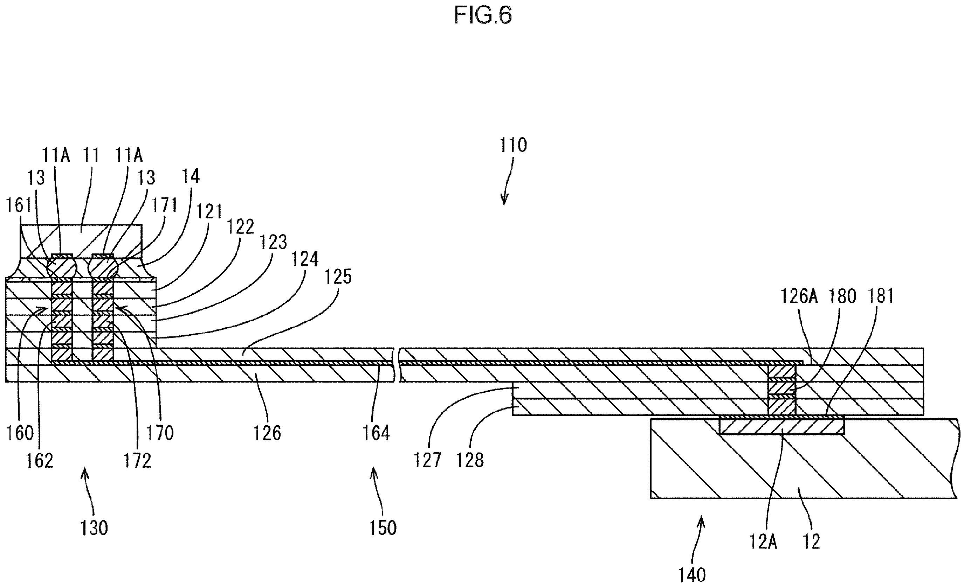

Referring to Figs. 4 to 6, an existing structure of the wiring board 10 according to the present disclosure will be described. Each component that is included in a wiring board 110 having the existing structure and that corresponds to a component of the wiring board 10 according to the present disclosure will be denoted by a symbol having a numeral part that is the sum of 100 and the numeral part of the symbol of the corresponding component of the wiring board 10. The pad pitch of the first pad 61 and the second pad 71 according to the present disclosure is less than the pair wiring pitch of the first strip conductor 64 and the second strip conductor 74. This also applies to the existing structure.

The difference between the wiring board 110 having the existing structure and the wiring board 10 according to the present disclosure is the wiring structure in an element connection portion 130. In the existing structure, a second via conductor 172 is connected to a second pad 171, the second via conductor 172 extends downward from the second pad 171 through a plurality of insulation layers (five insulation layers from a first insulation layer 121 to a fifth insulation layer 125), and a lower end portion of the second via conductor 172 is connected to a front end portion of a second inlet portion 175. That is, in the existing structure, conductors (strip lines) corresponding to the first planar conductor 63 and the second planar conductor 73 according to the present disclosure do not exist.

Because a first via conductor 162 and the second via conductor 172 extend downward while maintaining the pad pitch of a first pad 161 and the second pad 171, impedance mismatch occurs at this part. As a result, in the existing structure, the impedance mismatch part is generated to have a length corresponding to five insulation layers. On the other hand, in the present disclosure, because the first via conductor 62 and the second front via conductor 72F extend downward while maintaining the pad pitch of the first pad 61 and the second pad 71, impedance mismatch occurs at this part. However, the impedance mismatch part has only a length corresponding to one insulation layer. Therefore, the length of the impedance mismatch part in the present disclosure is reduced to 1/5 of that in the existing structure. Because the irregularities of impedance is reduced, electric characteristics such as the S parameters (Scattering parameters) are improved.

The length of the first planar conductor 63 is less than or equal to half the length of the first strip conductor 64, and the length of the second planar conductor 73 is less than or equal to half the length of the second strip conductor 74. Therefore, the length of the pair wiring is not too short, and the S parameter characteristics can be improved.

The characteristic impedance of the first planar conductor 63 is half the differential impedance of the pair wiring, and the characteristic impedance of the first planar conductor 63 and the characteristic impedance of the second planar conductor 73 are equal. The characteristic impedance of the first planar conductor 63 and the characteristic impedance of the second planar conductor 73 according to the present disclosure are each 50 **Ω.** The differential impedance of the pair wiring, which is constituted by the first strip conductor 64 and the second strip conductor 74 according to the present disclosure, is 100 **Ω.** In this way, by setting the characteristic impedance of the first planar conductor 63 and the characteristic impedance of the second planar conductor 73 to be half the differential impedance of the pair wiring, the irregularities of the impedance of the entire wiring can be reduced.

### [EXAMPLES]

Next, comparison of the S parameter characteristics, which differ according to the difference in the wiring structure in the element connection portion 30, will be performed. In the following examples, as shown in Fig. 1, the length of strip line (the planar conductor and the inlet) is denoted by L1, and the length of the differential transmission line (the strip-shaped conductor and the outlet) is denoted by L2; and, as shown in Fig. 2, the height of the first via conductor 62 is denoted by H.

Table 1 shows the values of reflection loss (dB) when the length L1 (mm) and the length L2 (mm) are changed.

**[Table 1]**

| No. | 1 | 2 | 3 | 4 | 5 | 6 |
|---|---|---|---|---|---|---|
| Length L1 (mm) | 0 (existing structure) | 0.75 | 1 (present disclosure) | 2 | 3 | 4 |
| Length L2 (mm) | 10 | 9.25 | 9 | 8 | 7 | 6 |
| Reflection Loss (dB) | -6.32 | -8.29 | -8.59 | -9.58 | -9.86 | -9.16 |

It can be seen from Table 1 that the reflection loss of No. 5 is the minimum. The structure according to the present disclosure, which is illustrated in Figs. 1 to 3, is No. 3; and the existing structure, which is illustrated in Figs. 4 to 6, is No. 1. It has been confirmed that, in the case of any of No. 2 to No. 6, the reflection loss is less than that of No. 1 of the existing structure.

Table 2 shows the values of reflection loss (dB) when the length L1 (mm) is maintained at 1 and only the height H (mm) is changed.

**[Table 2]**

| No. | 1 | 7 | 8 | 3 | 9 | 10 |
|---|---|---|---|---|---|---|
| Height H (mm) | 1.2 (existing structure) | 0.8 | 1 | 1.2 (present disclosure) | 1.4 | 1.6 |
| Reflection Loss (dB) | -6.32 | -8.21 | -8.37 | -8.59 | -8.78 | -9.01 |

It can be seen from Table 2 that the reflection loss of No. 10 is the minimum. The structure according to the present disclosure, which is illustrated in Figs. 1 to 3, is No. 3; and the existing structure, which is illustrated in Figs. 4 to 6, is No. 1. It has been confirmed that, in the case of any of No. 3 and Nos. 7 to 10, the reflection loss is less than that of No. 1 of the existing structure.

### [Advantageous Effects of Embodiments of Present Disclosure]

With the embodiment described above in detail, the following advantageous effects can be obtained.

(1) It is desirable that a part where the first via conductor 62 and the second front via conductor 72F are disposed side by side be as short as possible, because impedance mismatch occurs in this part. In this respect, with the configuration according to the present disclosure, the second planar conductor 73 is disposed along the stacking surface of an insulation layer that is closer than the first planar conductor 63 to the first insulation layer 21. Thus, it is possible to make the second front via conductor 72F shorter than the first via conductor 62. Accordingly, the impedance mismatch part can be made short, and electric characteristics can be improved.

Moreover, an end portion of the first via conductor 62 is connected to the first planar conductor 63 and the first wiring 60 can be extended from an end portion of the first planar conductor 63 to the intermediate connection portion 50 at the same layer. Thus, it is not necessary to configure the first wiring 60 in a step-like shape. Accordingly, the structure of the first wiring 60 can be simplified.

(2) In a case where the second planar conductor 73 is not provided in the element connection portion 30, the pair wiring can be made longer than that of a case where the second planar conductor 73 is provided in the element connection portion 30. Thus, an advantage can be obtained in this respect. However, in the case where the second planar conductor 73 is not provided in the element connection portion 30, the impedance mismatch part is longer than that of the case where the second planar conductor 73 is provided in the element connection portion 30. Thus, the electric characteristics of the entire wiring can be improved, even though the pair wiring is short.

(3) By setting the characteristic impedance of the first planar conductor 63 and the characteristic impedance of the second planar conductor 73 to be half (for example, 50 **Ω**) the differential impedance of the pair wiring (for example, 100 **Ω**), the irregularities of the impedance of the entire wiring can be reduced.

(4) Electric characteristics can be further improved, because the length of an impedance mismatch part can be limited to a length corresponding to one insulation layer.

(5) When the length of the first planar conductor 63 is made less than or equal to half the length of the first strip conductor 64, the S parameter characteristics can be improved.

### <Other Embodiments>

(1) In the embodiment described above, the first via conductor 62 is connected to the first strip conductor 64 through the first inlet portion 65. However, the first via conductor 62 may be directly connected to the first strip conductor 64. In the embodiment described above, the second planar conductor 73 is connected to the second rear via conductor 72R through the second inlet portion 75. However, the second planar conductor 73 may be directly connected to the second rear via conductor 72R.
(2) In the embodiment described above, the first strip conductor 64 and the second strip conductor 74 are disposed parallel to each other side by side. However, as long as the first strip conductor and the second strip conductor are disposed at a uniform distance from each other, it is not necessary that these strip conductors be linearly disposed side by side. For example, the first strip conductor and the second strip conductor both may have curved shapes and extend rearward.
(3) In the embodiment described above, the characteristic impedance of the first planar conductor 63 and the characteristic impedance of the second planar conductor 73 are equal. However, it is not necessary that these characteristic impedances be equal.
(4) In the embodiment described above, the second planar conductor 73 is disposed along the stacking surface 22A of the second insulation layer 22. However, the second planar conductor may be disposed along the stacking surface of any one of the third insulation layer 23 to the fifth insulation layer 25.
(5) In the embodiment described above, the length of the first planar conductor 63 is less than or equal to half the length of the first strip conductor 64. However, the length of the first planar conductor may be greater than half the length of the first strip conductor (No. 6 of Table 1) .
(6) In the embodiment described above, the second planar conductor 73 has a stripline structure in which the second planar conductor 73 is disposed along the stacking surface 22A of the second insulation layer 22. However, the second planar conductor may have a microstrip structure in which the second planar conductor is disposed at the same layer as the second pad 71 (on the upper surface of the first insulation layer 21).
(7) In the embodiment described above, the first planar conductor 63 has a stripline structure in which the first planar conductor 63 is disposed along the stacking surface 26A of the sixth insulation layer 26. However, the seventh insulation layer 27 and the eighth insulation layer 28 may each have a length equal to that of the sixth insulation layer 26, and the first planar conductor may have a microstrip structure in which the first planar conductor is disposed at the same layer as the land 81 (the lower surface of the eighth insulation layer 28). In this case, the first strip conductor and second strip conductor may also have a microstrip structure in which these strip conductors are disposed at the same layer as the land 81.

### Reference Signs List

- 10: wiring board
- 11: element 11A electrode
- 12: external circuit board 12A conductor
- 13: solder ball
- 14: sealant
- 20: dielectric substrate
- 21: first insulation layer
- 22: second insulation layer 22A stacking surface
- 23: third insulation layer
- 24: fourth insulation layer
- 25: fifth insulation layer
- 26: sixth insulation layer (intermediate insulation layer) 26A stacking surface
- 27: seventh insulation layer
- 28: eighth insulation layer
- 30: element connection portion
- 40: external connection portion
- 50: intermediate connection portion
- 60: first wiring
- 61: first pad
- 62: first via conductor
- 63: first planar conductor 63F front end portion 63R rear end portion
- 64: first strip conductor
- 65: first inlet portion
- 66: first outlet portion
- 70: second wiring
- 71: second pad
- 72F: second front via conductor 72R second rear via conductor
- 73: second planar conductor 73F front end portion 73R rear end portion
- 74: second strip conductor
- 75: second inlet portion
- 76: second outlet portion
- 80: via conductor
- 81: land

## Claims

1. A wiring board comprising: a dielectric substrate; and a first wiring and a second wiring to which differential signals are input,
wherein the dielectric substrate is configured by stacking a plurality of insulation layers,
wherein the dielectric substrate includes an element connection portion to be connected to an element, an external connection portion to be connected to an external circuit board, and an intermediate connection portion that has a shape extending in a direction perpendicular to a stacking direction and that intermediately connects the element connection portion and the external connection portion,
wherein a first pad and a second pad to be connected to the element are disposed on a first insulation layer that is one of the plurality of insulation layers and that is located at an end portion in the stacking direction,
wherein the first wiring includes a first via conductor that extends in the element connection portion from the first pad through the plurality of insulation layers in the stacking direction and a first planar conductor that extends in the element connection portion in the direction perpendicular to the stacking direction along an intermediate insulation layer that is one of the plurality of insulation layers and that extends continuously to the intermediate connection portion, and
wherein the second wiring includes a second via conductor that extends in the element connection portion through the insulation layer in the stacking direction and a second planar conductor that extends in the direction perpendicular to the stacking direction in the element connection portion along the first insulation layer or in the element connection portion along the insulation layer that is closer than the first planar conductor to the first insulation layer.

2. The wiring board according to Claim 1, wherein the second via conductor includes a second front via conductor (72F) that extends from the second pad through at least one of the insulation layers toward a front end portion of the second planar conductor in the stacking direction and a second rear via conductor (72R) that extends from a rear end portion of the second planar conductor through the plurality of insulation layers in the stacking direction.

3. The wiring board according to Claim 1 or 2, wherein the second planar conductor is disposed along a stacking surface (22A) of a second insulation layer that is disposed at a layer adjacent to the first insulation layer.

4. The wiring board according to any one of Claims 1 to 3,
wherein the first wiring includes a first strip conductor that extends in the intermediate connection portion in the direction perpendicular to the stacking direction,
wherein the second wiring includes a second strip conductor that is at the same layer as the first strip conductor in the intermediate connection portion and that is disposed at a uniform distance from the first strip conductor, and
wherein the first strip conductor and the second strip conductor constitute a pair wiring.

5. The wiring board according to Claim 4, wherein a characteristic impedance of the first planar conductor is half a differential impedance of the pair wiring, and a characteristic impedance of the first planar conductor and a characteristic impedance of the second planar conductor are equal.

6. The wiring board according to Claim 4 or 5, wherein a length of the first planar conductor is less than or equal to half a length of the first strip conductor.
